# EUROPÄISCHE PATENTSCHRIFT

(11) **EP 1 017 872 B1**
(45) Veröffentlichungstag und Bekanntmachung des Hinweises auf die Patenterteilung: **21.05.2003**
(21) Anmeldenummer: 98948802.8
(22) Anmeldetag: 12.08.1998
(51) Int. Cl.: C23C 14/34, C23C 14/50

(54) **EINRICHTUNG ZUM ZERSTÄUBEN VON HARTSTOFFSCHICHTEN**
DEVICE FOR APPLYING LAYERS OF HARD MATERIAL BY SPUTTERING
DISPOSITIF POUR REPARTIR DES COUCHES DE SUBSTANCE DURE PAR LA PULVERISATION CATHODIQUE

(30) Priorität: 02.09.1997 DE 19738234
(43) Veröffentlichungstag der Anmeldung: 12.07.2000
(73) Patentinhaber: FRAUNHOFER-GESELLSCHAFT ZUR FÖRDERUNG DER ANGEWANDTEN FORSCHUNG E.V., 80636 München (DE)
(72) Erfinder: GOEDICKE, Klaus, D-01307 Dresden (DE); FIETZKE, Fred, D-01127 Dresden (DE)
(86) Internationale Anmeldenummer: DE9802376
(87) Internationale Veröffentlichungsnummer: WO99011837

(56) Entgegenhaltungen:
- DE-A- 2 656 723
- DE-A- 2 815 704
- PATENT ABSTRACTS OF JAPAN vol. 016, no. 228 (C-0944), 27. Mai 1992 & JP 04 045265 A (MATSUSHITA ELECTRIC IND CO LTD), 14. Februar 1992

## Beschreibung

Die Erfindung betrifft eine Einrichtung zum Aufstäuben von Hartstoffschichten bei hohen Temperaturen. Ein bevorzugtes Anwendungsgebiet ist die Hartstoffbeschichtung von Umformwerkzeugen und Werkzeugen zur spanenden Bearbeitung durch Hochratezerstäuben mittels Magnetrons. Insbesondere betrifft die Erfindung Einrichtungen für Beschichtungstemperaturen von 400 °C bis 800 °C.

Es ist allgemein bekannt, Werkstücke - insbesondere Werkzeuge zur spanenden Bearbeitung von Metallen - sowie Umformwerkzeuge durch physikalische Dampfabscheidung (PVD) mit harten, verschleißfesten Schutzschichten zu überziehen. Die am häufigsten genutzten PVD-Verfahren für diese Anwendungen sind das Vakuum-Bogenverdampfen und das Magnetron-Zerstäuben. Die weiteste Verbreitung haben nach wie vor Schichten aus Titannitrid (Sue, J.A.; Troue, H.H.; Friction and wear properties of titanium nitride coating in sliding contact with AISI 01 steel; Surf. Coat. Technol. no. 43/44 (1990) p. 709-720).

Darüber hinaus sind eine Vielzahl anderer Schichten wie Nitride, Karbide, Karbo- und Oxynittide der Metalle Chrom, Niob, Zirkon, Titan u. a. als Hartstoffschicht bekannt (DE 295 10 545; US 4,169,913).

Weiterhin gibt es intensive Bemühungen zum Einsatz diamantähnlicher Kohlenstoffschichten, um harte und verschleißfeste Überzüge auf Werkstücken zu erzielen (EP 0 503 822).

Alle diese mittels PVD aufgebrachten Schichten werden bei vergleichsweise niedrigen Temperaturen, d.h. im Bereich zwischen Zimmertemperatur und etwa 400 °C, abgeschieden.

Bekannte PVD-Einrichtungen, wie sie für das Beschichten mittels Zerstäubungsquellen verwendet werden, besitzen eine oder mehrere Magnetronquellen für das Schichtmaterial. Die zu beschichtenden Werkstücke werden in Aufnahmen gehaltert und rotieren während der Beschichtung um eine oder mehrere Achsen. Ein Zerstäubungssystem mit dieser Gattung von Werkstückbewegung ist aus JP-A-4 045 265 bekannt. Auf diese Weise wird eine ausreichende Schichtgleichmäßigkeit gewährleistet. Die größte Zahl von Werkstücken je Beschichtung und die höchste Gleichmäßigkeit der Schichtdicke wird erreicht, wenn die Werkstücke auf einer Dreheinrichtung in Halterungen angeordnet sind, die Bestandteile von Planetengetrieben sind und sich dadurch um die Hauptachse des Planetengetriebes und zusätzlich um ihre eigene Achse drehen. Aus Wirtschaftlichkeitsgründen wird der Durchmesser dieser Halterungen möglichst groß gewählt. So entspricht ihr Durchmesser etwa 30 bis 40 Prozent des Durchmessers der Dreheinrichtung.

Am Umfang derartiger PVD-Einrichtungen sind außerhalb des Bereiches der rotierenden Halterungen flächenhafte Heizvorrichtungen angeordnet. Sie bestehen üblicherweise aus. Heizelementen, die in Edelstahlrohre eingebettet und gegen diese elektrisch isoliert sind. Um beim Beschichten Temperaturen der Werkstücke von 400 °C zu gewährleisten, sind Oberflächentemperaturen der Heizvorrichtungen von mindestens 600 bis 700 °C. erforderlich, und es muss ein nennenswerter Teil - in der Regel 20 bis 30 Prozent - des Umfangs der Dreheinrichtung von der Heizvorrichtung umschlossen sein. Dabei ist es unvermeidbar, dass ein großer Teil der Heizleistung auf die Wandungen der Vakuumkammer gelangt. Deshalb werden die Wandungen mit Wasserkühlung versehen. Nach erfolgter Beschichtung wird die Vakuumkammer belüftet. Die beschichteten Werkstücke werden aus ihren Halterungen entnommen und andere zu beschichtende Werkstücke eingesetzt. Dabei lässt sich die Dreheinrichtung von den Antriebselementen lösen und als Ganzes aus der Vakuumkammer entnehmen. Die Heizvorrichtungen verbleiben stets in der Vakuumkammer. Die kürzesten Wechselzeiten werden erreicht, wenn eine zweite, mit Werkstücken bestückte Dreheinrichtung bereitsteht und in die Vakuumkammer eingefahren wird.

Die Nachteile derartiger Einrichtungen bestehen darin, dass die Leistungsdichte der Heizelemente nicht so weit gesteigert werden kann, dass eine Werkstücktemperatur von 800 °C erreicht wird. D.h. sie können im Temperaturbereich oberhalb von etwa 500 °C nicht eingesetzt werden. Desweiteren vergrößern sich schon in Temperaturbereichen bis 500 °C die Temperaturunterschiede sowohl zwischen den Werkstücken als auch in jedem einzelnen Werkstück mit steigender Temperatur. Zugleich ist die Temperatur des einzelnen Werkstückes großen zeitlichen Schwankungen unterworfen. So entstehen in den aufwachsenden Schichten überkritische innere Spannungen, die zum Abplatzen der Schichten führen.

Dadurch, dass außer den Werkstücken auch die Halterungen, die Dreheinrichtung, die Heizvorrichtungen und alle inneren Flächen der Vakuumkammer beschichtet werden, ist einweiterer wesentlicher Nachteil, dass sich von diesen Flächen Schichtpartikel lösen. Diese z.T. elektrisch aufgeladenen Schichtpartikel - sogenannte Flitter - führen zu großen Problemen, da sie die Qualität der aufgestäubten Hartstoffschichten so stark negativ beeinflussen, dass die Standzeiten derart beschichteter Werkstücke sehr gering sind.

Letztendlich verringert sich durch kondensierende Schichten auf den Heizvorrichtungen die zum Heizen der Werkstücke zur Verfügung stehende Heizleistung, und die Wärmeverluste nehmen in Richtung zu den Wandungen der Vakuumkammer unzulässig hohe Werte an. Die Reinigung der Einrichtung, insbesondere der Heizvorrichtungen, ist mit Schwierigkeiten verbunden.

Der Erfindung liegt die Aufgabe zugrunde, eine Einrichtung zum Aufstäuben von Hartstoffschichten bei hohen Temperaturen bis zu 800 °C zu schaffen. Mit der Einrichtung soll es möglich sein, Teile - insbesondere Werkstücke - so zu beschichten, dass sich sowohl zwischen den Teilen als auch in jedem Teil keine größeren Temperaturgradienten ausbilden, um qualitativ hochwertige Schichten aufstäuben zu können. Es sollen innere Spannungen in der.Schicht verhindert und die Anzahl von Störstellen minimiert werden. Die Einrichtung soll weiterhin das Entstehen von störenden Partikeln, insbesondere Flittern, begrenzen. Die Einrichtung soll auch die für den Gesamtprozess des Aufstäubens erforderliche Vorbehandlung ermöglichen. Die Zeiten beim Be- und Entstücken der Teile sollen kurz sein, um die Produktivität zu erhöhen. Der Aufwand für die Reinigung der Einrichtung soll verringert werden.

Erfindungsgemäß wird die Aufgabe mit Merkmalen gemäß Anspruch 1 gelöst. Weitere Ausgestaltungen sind in den Ansprüchen 2 bis 6 beschrieben.

Die erfindungsgemäße Einrichtung besteht aus einer evakuierbaren Vakuumkammer, in deren Innerm sich eine auswechselbare Grundplatte befindet. Als Grundplatte wird dabei jede beliebige Ausgestaltung, die als Montagebasis geeignet ist, angesehen. Auf dieser Grundplatte sind koaxial Blenden angeordnet. Diese Blenden besitzen Öffnungen, die den Austrittsflächen von am Umfang der Vakuumkammer angeordneten Zerstäubungsquellen entsprechen. Innerhalb der Blenden ist zentral eine Heizvorrichtung angeordnet, die von Halterungen zur Aufnahme von zu beschichtenden Teilen umgeben ist. Die Halterungen sind auf Planetenrädern eines Planetengetriebes angeordnet und führen in bekannter Weise eine Planetenbewegung durch. Die Achsen der Planetenräder befinden sich auf einem Teilkreis mit einem Durchmesser von mindestens ¾ des Durchmessers der Grundplatte. Über und unter der Heizvorrichtung sind feststehende Schirmbleche angeordnet.

Die erfindungsgemäße Ausgestaltung und zentrale Position der Heizvorrichtung im Inneren der Blenden und Schirmbleche gewährleistet eine vollständige Nutzung der Heizleistung für die Erwärmung der Teile. Die dadurch erreichbare Rotationssymmetrie für die Wärmeabstrahlung führt zusammen mit der Bemessungsregel für die Halterungen zu einer Reduktion von Temperaturgradienten gegenüber herkömmlichen Einrichtungen. Die Anordnung der Halterungen mittels Wärmeleitbarrieren, vorzugsweise als keramische Wärmewiderstände, führt zu einer weiteren Minimierung von Wärmeverlusten. Die Vorteile der Anordnung und Ausbildung der Heizvorrichtung sind die gleichmäßig hohe Oberflächentemperatur und eine hohe Heizleistüngsdichte, ein hoher Abstrahlungskoeffizient, der stabile Betrieb auch unter den Bedingungen permanenter Beschichtung, die Vermeidung von Flitterbildung und die gute Eignung für Reinigungsprozesse.

Erfindungsgemäß sind die Blenden relativ zueinander und zur Grundplatte radial bewegbar. Diese Blenden sind so gestaltet, dass sie in bestimmten Stellungen zueinander die Durchführung unterschiedlicher Prozessschritte unter verbesserten Bedingungen ermöglichen.

Für den Prozessschritt "Heizen" werden die Heizvorrichtung und die Halterungen durch die entsprechende Stellung der Blenden nahezu vollständig umschlossen. Somit wird eine Minimierung der Wärmeverluste, die durch Wärmeableitung über die Wandungen der Vakuumkammer entstehen, erreicht.

In einer weiteren Stellung der Blenden ist eine "Vorbehandlung" der Teile in einem dichten magnetfeldverstärkten Plasma möglich. Dazu werden die Blenden so bewegt, dass die Öffnungen in den Blenden entsprechende Vorbehandlungseinrichtungen für die Teile freigeben.

Für den Prozessschritt "Beschichten" lassen sich die Blenden so positionieren, dass Öffnungen in den Blenden nunmehr die Zerstäubungsquellen für das Beschichten der Teile freigeben. Die Halterungen sind elektrisch isoliert angeordnet und in Abhängigkeit vom jeweiligen Prozessschritt auf unterschiedliche elektrische Potentiale legbar.

Die weiteren Vorteile der Blenden bestehen darin, dass eine Beschichtung der inneren Flächen der Vakuumkammer verhindert wird und die Temperatur der Blenden und Schirmbleche sich während der Beschichtung auf solche Werte einstellt, dass sie selbst keine Quelle von Flittern darstellen.

Andererseits sind die Blenden und Schirmbleche so gestaltet, dass ein ausreichendes Saugvermögen der Vakuumpumpen auch im Inneren der Einrichtung wirksam ist.

Zum Wechseln der Teile lässt sich die Grundplatte mit der Heizvorrichtung, den Halterungen, den Blenden und den Schirmblechen als integrierte Baugruppe aus der Vakuumkammer herausfahren. Dadurch ist es möglich, die Blenden, die Schirmbleche sowie gegebenenfalls die Heizvorrichtung durch mechanische Behandlung - z.B. durch Sandstrahlen - zu reinigen.

Ein weiterer Vorteil der auswechselbaren Grundplatte besteht darin, dass diese nach dem Aufstäubungsprozess mit den beschichteten Teilen gegen eine andere Grundplatte mit zu beschichtenden Teilen gewechselt werden kann. Somit kann ein Reinigungsprozess parallel zum nächsten Aufstäubungsprozess durchgeführt werden. Damit wird die Effektivität der Einrichtung erhöht.

Vorteilhafte Ausgestaltungen der Einrichtung bestehen darin, die Heizvorrichtung, welche direkt vom Strom durchflossen wird, rotationssymmetrisch aus Graphit oder Kohlefaserverbundmaterialien herzustellen. Eine kostengünstige Ausführungsform nutzt ein Gräphitrohr. Dieses ist zur Erhöhung der Gleichmäßigkeit der Wärmestrahlung und zur Anpassung an die Stromversorgungseinrichtung durch geeignet dimensionierte Trennfugen strukturiert. Am vorteilhaftesten werden die Trennfugen mäanderförmig eingebracht. Die Trennfugen sind mit mechanischen Methoden in das Graphitrohr eingebracht. Als vorteilhafte Ausgestaltung ist es in Abhängigkeit von der Größe der zu beschichtenden Teile möglich, auf jeder Halterung die zu beschichtenden Teile in mehreren Ebenen übereinander anzuordnen. Dadurch wird die Produktivität der Einrichtung weiter erhöht.

Es ist weiterhin vorteilhaft, die Blenden und Schirmbleche aus warmfestem Material wie Edelstahl, Titan oder Molybdän herzustellen. Das innere Schirmblech und die innere Blende werden vorzugsweise mit sehr großer Oberflächenrauheit ausgestattet. Es ist auch zweckmäßig, die Oberfläche mit rauhen, stark verformten, z.B. netzartigen Verkleidungen zu versehen. Auf diese Weise wird die Entstehung von Flittern weiter verringert. Die äußeren Schirmbleche und die äußeren Blenden haben dagegen sehr glatte, hochreflektierende Oberflächen.
Zur Bewegung der Blenden sind diese mit getrennten motorischen Antrieben versehen. Besonders vorteilhaft sind Ausführungen für den Antrieb der Blenden, die nur mechanische Verbindungselemente im inneren der Vakuumkammer besitzen. Der Motor ist außerhalb der Vakuumkammer angeordnet.

Durch die isolierte Anordnung der Halterungen ist es möglich, entsprechend dem durchzuführenen Prozess unterschiedliche Potentiale mittels bekannter Schaltelemente anzulegen.

Auf diese Weise werden die Zerstäubungsquellen neben dem Prozessschritt "Beschichten" auch für den Prozessschritt "Vorbehandlung" genutzt. Durch die Verwendung der Zerstäubungsquellen für eine Plasmavorbehandlung wird eine Konzentrierung und Verstärkung des Plasmas erreicht. Damit wird die Wirkung dieses Prozessschrittes erhöht und eine Verkürzung der Vorbehandlungszeit erreicht.

Es ist auch möglich, anstatt von Magnetrons Bogenverdampfer als Quellen für das Beschichtungsmaterial zu verwenden.

An einem Ausführungsbeispiel wird die Erfindung erläutert. Dabei zeigen:
- Fig. 1:: einen Querschnitt der Einrichtung,
- Fig. 2:: einen Längsschnitt und
- Fig. 3a bis 3c:: die prinzipielle Funktion der Blenden.

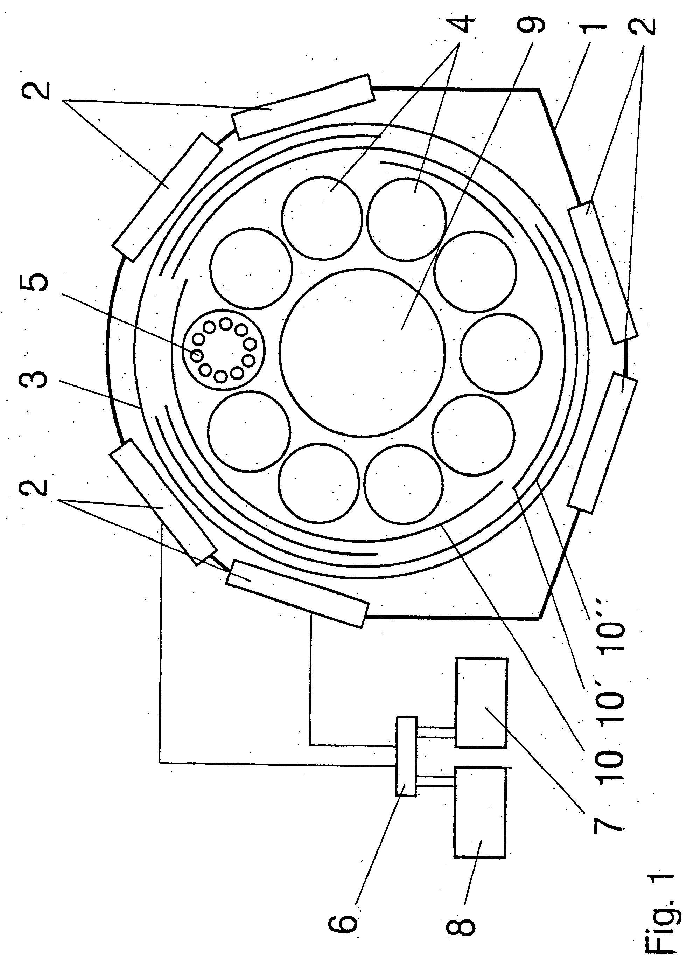

In Fig. 1 sind in einer Vakuumkammer 1 drei Doppel-Magnetrons 2 angeordnet, um durch reaktives Puls-Magnetronzerstäuben elektrisch isolierende Oxidschichten aufzubringen. In der Vakuumkammer 1 ist eine Grundplatte 3 angeordnet. Unterhalb der Grundplatte 3 ist ein Planetengetriebe mit zehn Planetenrädern (nicht dargestellt) angeordnet. Jedes Planetenrad ist mit einer Halterung 4 verbunden. Auf jeder Halterung 4 sind jeweils zehn zu beschichtende Teile 5 in bekannter Weise angeordnet. Die Halterungen 4 sind so ausgebildet, dass jedes zu beschichtende Teil 5 eine Rotation um seine eigene Achse und um die Achse der Halterung durchführt.
Die Halterungen 4 sind gegenüber dem Erdpotential elektrisch isoliert.
Mittels eines Schalters 6 werden die Halterungen 4 mit einem Pol einer Stromversorgung 7 verbunden, deren anderer Pol mit den Doppel-Magnetrons 2 verbunden ist. Auf diese Weise läßt sich ein sehr wirkungsvoller magnetfeldverstärkter Plasmaprozess zur Vorbehandlung der Teile 5 vor der Beschichtung realisieren. In einer anderen Stellung des Schalters 6 sind die Halterungen 4 geerdet, und die Doppel-Magnetrons 2 sind mit einer Zerstäubungs-Stromversorgung 8 verbunden, welche einen bipolaren gepulsten Strom erzeugt.
Die Halterungen 4 haben einen Durchmesser von 150 mm. Ihre Achsen sind auf einem Teilkreis von 525 mm Durchmesser angeordnet Bei einem Durchmesser der Grundplatte 3 von 700 mm misst der Teilkreis ¾ dieses Durchmessers.
Im Zentrum der Grundplatte 3 befindet sich eine Heizvorrichtung 9. Sie besteht aus einem mäanderförmig geschlitzten Rohr aus Kohlefaser-Verbundwerkstoff, welches einen Durchmesser von 350 mm aufweist. Die Heizvorrichtung 9 erreicht Oberflächentemperaturen von 1100 °C.
Auf der Grundplatte 3 sind Blenden 10 bis 10" konzentrisch angeordnet. Die Blenden 10 bis 10" lassen sich jeweils mittels eines Motors außerhalb des Vakuumkammer 1, einer Dreh/Schiebedurchführung und eines Zahnradgetriebes einzeln ansteuern. Die Blenden 10 bis 10" enthalten Öffnungen, deren Größe und Form im Wesentlichen den Austrittsflächen der zerstäubten Teilchen der Doppel-Magnetrons 2 entsprechen.

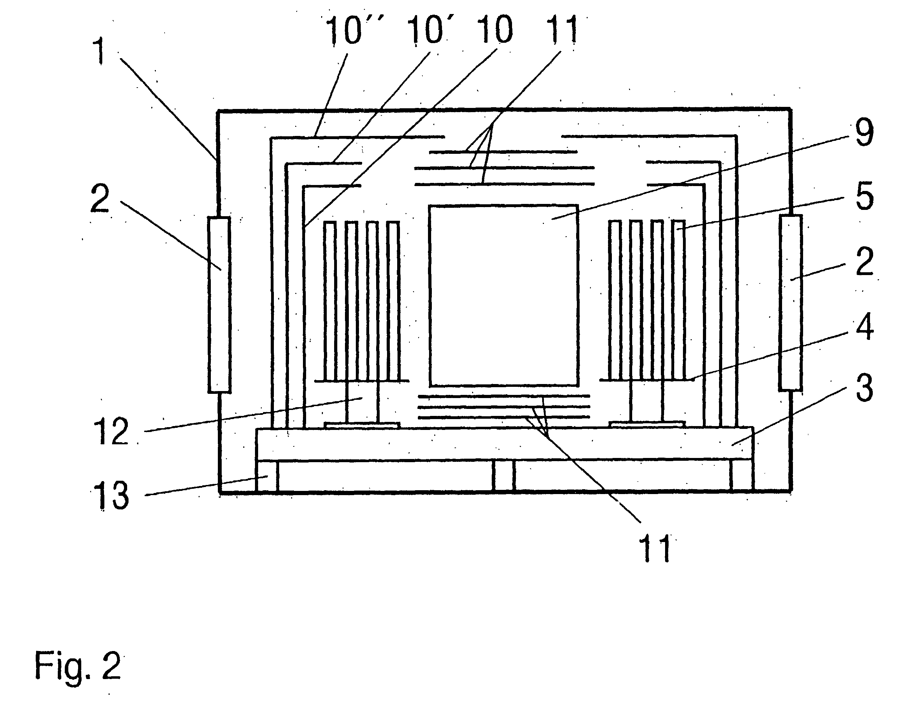

Fig. 2 zeigt ebenfalls die Vakuumkammer 1 mit den am Umfang angeordneten Doppel-Magentrons 2. Auf der Grundplatte 3 sind die Heizvorrichtung 9, die Halterungen 4 und die Blenden 10 bis 10" angeordnet. Ober- und unterhalb der Heizvorrichtung 9 sind feststehende scheibenförmige Schirmbleche 11 angeordnet. Die innere Blende 10 und die inneren Schirmbleche bestehen aus Molybdän. Auf ihrer der Heizvorrichtung 9 zugewandten Seite sind sie mit einer siebartig perforierten Auskleidung (nicht dargestellt) belegt. Diese Auskleidung ist in der Lage, nicht genutzte Anteile der schichtbildenden Partikel mechanisch fest zu binden. Nach einer festgesetzten Nutzungszeit wird die siebartig perforierte Auskleidung erneuert. Die Blenden 10', 10" und die äußeren Schirmbleche bestehen aus Edelstahlblech und sind beidseitig poliert. Auf diese Weise wird eine sehr hohe Reflexion der von allen Bauteilen innerhalb der Blenden 10 bis 10" abgestrahlten Wärme erreicht. Die Gestaltung der Blenden 10 bis 10" und Schirmbleche 11 verhindert den direkten Weg zerstäubter Teilchen auf die Innenwände der Vakuumkammer 1, sichert aber ein ausreichend hohes Saugvermögen der Vakuumpumpen von 200 Is⁻¹ im Bereich der Halterungen 4. Die Halterungen 4 sind durch die Grundplatte 3 mit den nicht dargestellten Planetenrädern des Planetengetriebes mechanisch verbunden. Zwischen den Planetenrädern und den Halterungen 4 befinden sich keramische Wärmewiderstände 12. Mittels Rollen 13 lässt sich die gesamte Grundplatte 3 auf Schienen aus der geöffneten Vakuumkammer 1 herausfahren. Eine gleichartige Grundplatte mit zu beschichtenden Teilen 5 wird in die Vakuumkammer 1 eingefahren, um den nächsten Beschichtungsprozess durchzuführen. Während dieser Zeit erfolgt die Entnahme der beschichteten Teile 5 aus den Halterungen 4 der ersten Grundplatte 3. Dazu werden die Blenden 10 bis 10" abgehoben. Nach einer Abkühlphase werden die Teile 5 entnommen, Halterungen 4 und die innere Blende 10 werden gegebenenfalls gereinigt. Anschließend erfolgt eine Neubestückung.

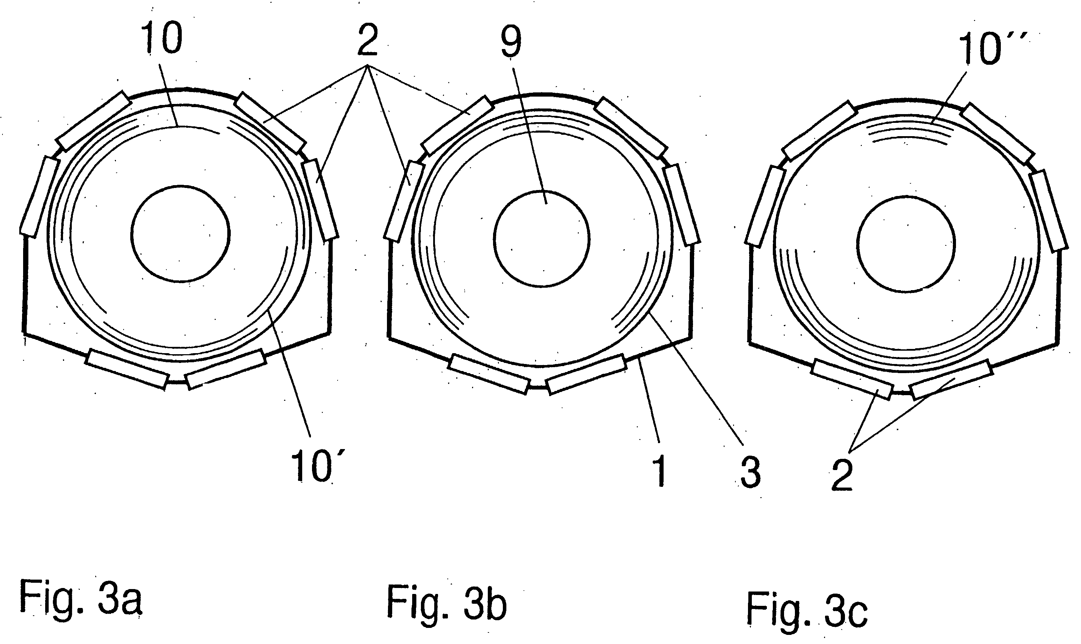

In den Fig. 3a bis 3c ist die Funktionsweise der Blenden 10 bis 10" ohne die Halterungen 4 dargestellt. Zum Prozessschritt "Heizen" befinden sich die Blenden 10 bis 10" in der Stellung gemäß Figur 3a, in der alle Doppel-Magnetrons 2 gegenüber den Teilen 5 abgedeckt sind. Während des Prozessschrittes "Plasmavorbehandeln" befinden sich die Blenden 10 bis 10" in der Stellung gemäß Figur 3b. Die Teile 5 sind dabei unter Nützung eines Doppel-Magnetrons 2 einem dichten, magnetfeldverstärkten Plasma ausgesetzt. Während des Prozessschrittes "Beschichten" werden die Blenden 10 bis 10" derart positioniert, dass die Öffnungen der Blenden 10 bis 10" die Austrittsflächen zweier Doppel-Magnetrons 2 zur Beschichtung freigeben.

## Patentansprüche

1. Einrichtung zum Aufstäuben von Hartstoffschichten, bestehend aus
- einer evakuierbaren Vakuumkammer (1),
- mindestens einer Zerstäubungsquelle (2) mit mindestens einem Target aus Zerstäubungsmaterial oder dessen Komponenten, wobei die Zerstäubungsquelle (2) um den äußeren Rand einer Grundplatte (3) angeordnet ist sind, und deren Austrittsfläche für die zerstäubten Teilchen parallel zur Hauptachse verläuft,
- einem Reaktivgaseinlass,
- einer Vorrichtung mit einem Planetengetriebe, dessen Hauptachse senkrecht auf der Grundplatte (3) angeordnet ist und auf dessen Planetenrädern Halterungen (4) zur Aufnahme der zu beschichtenden Teile (5) elektrisch isoliert angeordnet sind und deren zu beschichtende Flächen parallel zur Hauptachse verlaufen, wobei der Durchmesser des Teilkreises der Planetenräder mindestens ¾ des Durchmessers der Grundplatte (3) beträgt,
- einer im Zentrum des Planetengetriebes innerhalb der Halterungen (4) angeordneten Heizeinrichtung (9),
- koaxial auf der Grundplatte (3) um die Hauptachse unabhängig voneinander radial bewegbaren, zwischen den Halterungen (4) und der Zerstäubungsquelle (2) angeordneten Blenden (10 bis 10"), wobei in die Blenden (10 bis 10") Öffnungen im Bereich der Austrittsfläche der von der Zerstäubungsquelle (2) abgestäubten Teilchen eingebracht sind und die Zerstäubungsquelle (2) einzeln oder alle wahlweise abdeckbar ist sind,
- Schirmblechen (11), die den Bereich der Zerstäubung abschließen und oberhalb und unterhalb der Heizeinrichtung (9) quer zur Hauptachse in axialer Richtung feststehend angeordnet sind,
- einer Baugruppe aus der Heizvorrichtung (9), den Blenden (10 bis 10") und dem Planetengetriebe mit den Halterungen (4), die zum Be- und Entstücken der Teile (5) auswechselbar sind.

2. Einrichtung nach Anspruch 1, **dadurch gekennzeichnet, dass** die Heizvorrichtung (9) aus einem stromdurchflossenen Rohr aus Kohlenstoff besteht.

3. Einrichtung nach Anspruch 2, **dadurch gekennzeichnet, dass** das Rohr durch Trennfugen, vorzugsweise mäanderförmig, strukturiert ist.

4. Einrichtung nach Anspruch. 1 bis 3, **dadurch gekennzeichnet, dass** die innere Blende (10) und die inneren Schirmbleche auf der Innenseite aus einem Material mit hoher Rauhigkeit bestehen.

5. Einrichtung nach Anspruch 1 bis 4, **dadurch gekennzeichnet, dass** mindestens die äußere Blende (10'') und das äußere Schirmblech eine hochreflektierende Oberfläche besitzen.

6. Einrichtung nach Anspruch 1 bis 5, **dadurch gekennzeichnet, dass** Schaltelemente zum Anlegen von unterschiedlichen Potentialen an die Zerstäubungsquelle (2) und die Halterungen (4) angeordnet sind.

## Claims

1. Device for applying hard-material layers by sputtering, comprising
- a vacuum chamber (1) which can be evacuated,
- at least one sputtering source (2) having at least one target made from sputtering material or components thereof, the sputtering source (2) being arranged around the outer edge of a base plate (3) and the outlet surface of this source for the sputter particles running parallel to the main axis,
- a reactive gas inlet,
- an appliance with a planetary gear mechanism, the main axis of which is arranged perpendicular to the base plate (3) and on the planet wheels of which holders (4) for receiving the parts (5) which are to be coated are arranged in an electrically insulated fashion, the surfaces of these parts which are to be coated running parallel to the main axis, the diameter of the pitch circle of the planet wheels being at least 3/4 of the diameter of the base plate (3),
- a heating device (9), which is arranged in the centre of the planetary gear mechanism inside the holders (4),
- diaphragms (10 to 10") which are arranged between the holders (4) and the sputtering source (2) and can be moved radially about the main axis, independently of one another, coaxially on the base plate (3), wherein openings are formed in the diaphragms (10 to 10") in the region of the outlet surface of the particles which have been removed from the sputtering source (2), and wherein the sputtering source (2) may be individually or all covered as desired,
- metal shielding plates (11) which close off the sputtering area and are arranged in a fixed position in the axial direction, above and below the heating device (9), transversely with respect to the main axis,
- an assembly comprising the heating appliance (9), the diaphragms (10 to 10") and the planetary gear mechanism with the holders (4), which are exchangeable in order to mount and remove the parts (5).

2. Device according to Claim 1, **characterized in that** the heating appliance (9) consists of a carbon tube through which current flows.

3. Device according to Claim 2, **characterized in that** the tube is structured, preferably in meandering form, by parting joints.

4. Device according to Claims 1 to 3, **characterized in that** the inner diaphragm (10) and the inner metal shielding plates, on the inner side, consist of a material with a high roughness.

5. Device according to Claims 1 to 4, **characterized in that** at least the outer diaphragm (10") and the outer metal shielding plate have a highly reflective surface.

6. Device according to Claims 1 to 5, **characterized in that** there are switching elements for applying different potentials to the sputtering source (2) and the holders (4).

## Revendications

1. Installation pour pulvériser des couches de matière dure comprenant :
- une chambre à vide (1), mise sous vide,
- au moins une source de pulvérisation (2) avec au moins une cible composée d'une matière à pulvériser ou des composants de cette matière, la source de pulvérisation (2) étant prévue au niveau du bord extérieur d'une plaque de base (3) et la surface de sortie des particules pulvérisées étant parallèle à l'axe principal,
- une entrée de gaz de réaction,
- un dispositif avec une transmission planétaire dont l'axe principal est perpendiculaire à la plaque de base (3) et dont les roues planétaires comportent des moyens de fixation (4) pour recevoir les pièces (5) à revêtir, installés de manière isolée électriquement et dont les surfaces à revêtir sont parallèles à l'axe principal,
le diamètre du cercle primitif des roues planétaires représentant au moins 3/4 du diamètre de la plaque de base (3),
- une installation de chauffage (9) prévue au centre de la transmission planétaire à l'intérieur des fixations (4),
- des diaphragmes (10-10") prévus coaxialement à la plaque de base (3), mobiles radialement de façon indépendante autour de l'axe principal entre les fixations (4) et la source de pulvérisation (2), des diaphragmes (10-10") comportant des ouvertures au niveau de la surface de sortie des particules éjectées de la source de pulvérisation (2) et la source de pulvérisation (2) pouvant être couverte sélectivement seule ou avec d'autres,
- des écrans en tôle (11) qui ferment la zone de pulvérisation et sont installées de manière fixe au-dessus et en dessous de l'installation de chauffage (9), transversalement à l'axe principal dans la direction axiale,
- un ensemble échangeable comprenant le dispositif de chauffage (9), les diaphragmes (10-10") et de la transmission planétaire avec les moyens de fixation (4) pour la mise en place et l'enlèvement des pièces (5).

2. Installation selon la revendication 1,
**caractérisée en ce que**
le dispositif de chauffage (9) est formé d'un tube en carbone dans lequel on fait passer le courant.

3. Installation selon la revendication 2,
**caractérisée en ce que**
le tube est structuré de préférence suivant une forme de méandres par des intervalles de séparation.

4. Installation selon les revendications 1 à 3,
**caractérisée en ce que**
les diaphragmes intérieurs (10) et les écrans intérieurs en ont une face intérieure en une matière à forte rugosité.

5. Installation selon les revendications 1 à 4,
**caractérisée en ce qu'**
au moins l'écran extérieur (10") et l'écran extérieur en ont une surface fortement réfléchissante.

6. Installation selon les revendications 1 à 5,
**caractérisée par**
des éléments de commutation pour appliquer des potentiels différents à la source de pulvérisation (2) et aux moyens de fixation (4).
